# EUROPEAN PATENT APPLICATION

(11) **EP 3 170 664 A2**
(43) Date of publication of application: **24.05.2017**
(21) Application number: 16002457.6
(22) Date of filing: 18.11.2016
(51) Int. Cl.: B41F 15/08, B41F 15/36, H05K 3/34, H05K 13/04

(54) **METHOD AND APPARATUS FOR SELECTING A PASTE STENCIL FOR PASTE PRINTING AND FOR APPLYING PASTE ONTO A SUBSTRATE BY MEANS OF THE SELECTED PASTE STENCIL**

(30) Priority: 20.11.2015 DE 102015120185
(71) Applicant: ASM Assembly Systems GmbH & Co. KG, 81379 München (DE)
(72) Inventor: LIEGEL, Werner, 82392 Habach (DE)
(74) Representative: Griebling, Onno

(57) **Abstract**

The invention relates to a method and an apparatus for selecting a paste stencil (10) for paste printing onto a substrate (20), the paste stencil (10) being selected on the basis of a stencil thickness (h), in the case of which an area ratio of a small through opening (11 a, 11 b) of the substrate is greater than or equal to a setpoint area ratio. Furthermore, the present invention relates to a method and an apparatus for applying paste material (30) onto a substrate (20) for at least one small component (21 a, 21 b) and at least one large component (22) which is larger than the at least one small component (21 a, 21 b), paste material (30) being applied for the at least one small component (21 a, 21 b) and the at least one large component (22) by means of a paste stencil (10) which is selected according to the invention, and additional paste material (30) being applied onto the paste material (30) for the at least one large component (22), after paste material (30) has been applied by means of the selected paste stencil (10) for the at least one small component (21 a, 21 b) and the at least one large component (22).

## Description

The invention relates to a method and an apparatus for selecting a paste stencil for paste printing and for applying paste onto a substrate by means of the selected paste stencil.

### PRIOR ART

In order to produce soldered connections on a substrate, for example a printed circuit board, solder deposits are produced on the substrate during paste printing, in particular soldering paste printing. Here, a soldering paste, consisting of spherical soldering powder and a pasty flux system, is pressed in a stencil printing method, for example with the aid of a squeegee, through through openings of the soldering paste stencil which has previously been oriented with respect to the substrate. Since the result of the printing process has a fundamental influence on all following processes such as population and a reflow soldering operation, the said production step is given great significance. Since a multiplicity of quality-influencing factors and parameters come into effect here, the printing process in SMD production at the same time represents one of the production steps which are most difficult to master. For instance, machine parameters such as contact pressure or advancing of the squeegee and the release speed of the table can be factors which determine the quality just as much as rheological properties and a thixotropic behavior of the soldering paste.

It is estimated that, during the production of SMD printed circuit boards, more than half of all production faults are caused by the soldering paste printing operation, for example on account of an unsuitable design of the soldering paste stencil, an unsuitable material of the soldering paste stencil and/or unsuitable printing parameters.

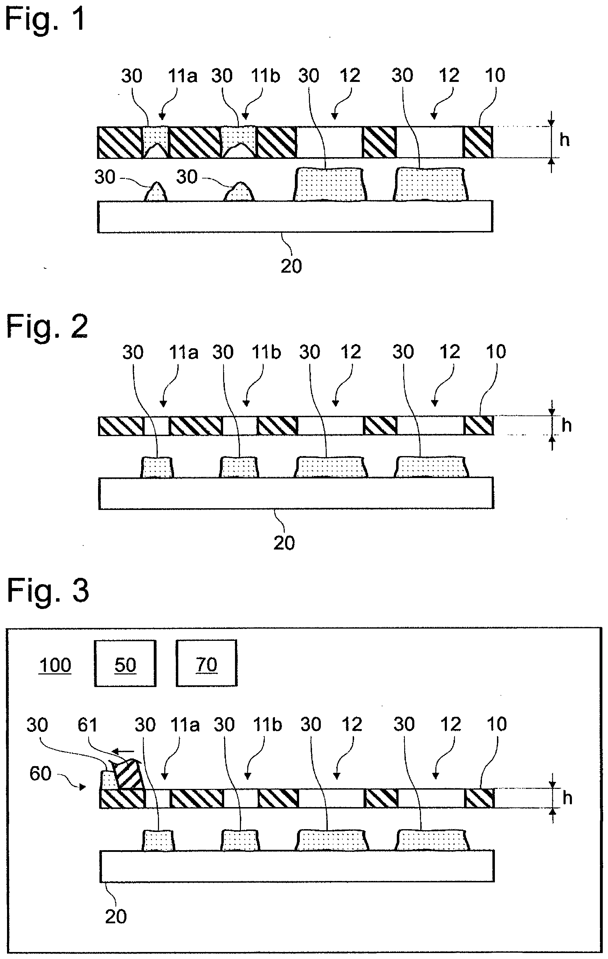

Problems occur during printing with paste material, for example during soldering paste printing, in particular when components of different size have to be arranged on a substrate. If small components, such as fine pitch components, are to be arranged on a substrate, the preferred stencil thickness of the paste stencil would be, for example, 80 µm. If large components, such as plugs or coils, are also to be arranged on the substrate, which large components require greater soldering paste deposits, a stencil thickness of approximately 120 µm would be necessary. If a stencil thickness of 120 µm is then selected for the entire substrate, there is the risk that sufficient soldering paste for the small components cannot be applied, since the area ratio, that is to say the ratio of the area of the opening cross section of a through opening in the soldering paste stencil to the area of the wall region of the through opening, can lead to an unstable printing process. This problem is shown in Figure 1. The area ratio is too small in the through openings 11 a and 11 b in Figure 1, as a result of which soldering paste residues are formed in the through openings 11 a and 11 b on account of wall adhesion and capillary effects.

In order to avoid the problems shown in Figure 1 during the use of components of different size, stepped stencils with regions of different stencil thicknesses are used in the prior art. However, the possibility of the application of this method is greatly dependent on the printed circuit board design, in particular on minimum spacings of the components of different size with different soldering paste requirements.

US 2015/0163969 A1 has disclosed a method for applying soldering paste onto a substrate in different layer thicknesses. Here, in a stencil printer, correspondingly small soldering deposits are applied for small components by means of a soldering paste stencil which is closed at locations for solder deposits for large components or does not have any through holes. That is to say, in a first step, first of all only solder deposits for small components are applied onto the substrate by means of the soldering paste stencil. In a following processing station, the locations on the substrate for the large components are coated with soldering paste by means of a dispenser. However, the application of paste material by means of dispenser is more complicated than the application of paste material by means of paste stencil.

DE 10 2007 019 073 A1 has disclosed a printing device for applying paste material onto flat substrates, in which printing device first of all paste material is applied onto the substrate by means of a stencil and subsequently paste material is supplemented by way of a dispenser. The following question arises here, however: according to which rule is the paste material to be coated additionally to be selected or with which thickness is the said paste material to be subsequently coated?

### DISCLOSURE OF THE INVENTION

It is an object of the present invention to at least partially eliminate the above-described disadvantages. In particular, it is an object of the present invention to provide an apparatus and a method, by means of which a suitable paste stencil for paste printing onto a substrate in a manner which is dependent on components which are used for the substrate can be provided. Moreover, it is an object of the present invention to provide an apparatus and a method, by means of which sufficient paste material for components of different size can be applied on the substrate inexpensively, rapidly and reliably.

The above object is achieved by way of the patent claims. Further features and details of the invention result from the description and the drawings. Here, it goes without saying that features and details which are described in conjunction with the method also apply in conjunction with the apparatus according to the invention and vice versa in each case, with the result that reference is made or can be made mutually at all times with regard to the disclosure with respect to the individual aspects of the invention.

According to a first aspect of the present invention, a method for selecting a paste stencil for paste printing onto a substrate is provided, the paste stencil having at least one small through opening for paste material for at least one associated small component on the substrate and at least one large through opening for paste material for at least one associated large component on the substrate, and the at least one small through opening having a smaller opening cross section than the at least one large through opening. Here, the at least one small through opening has a first area ratio and the at least one large through opening has a second area ratio which is greater than the first area ratio. According to the method, the paste stencil is selected on the basis of a stencil thickness, in the case of which the first area ratio is greater than or equal to a setpoint area ratio.

By way of the method according to the invention, a paste stencil with through openings of different size for paste material for components of different size is selected, by means of which paste stencil paste material can be applied onto the substrate for each of the components of different size, it being possible for clogging or residues in one of the through openings to be avoided. Here, the setpoint area ratio is fixed by means of Gerber data and can assume different values depending on the type and size of the different components, that is to say of the at least one small component and the at least one large component, and the type of paste material.

In order to select the paste stencil, the first area ratio in the case of a fixed opening cross section of the at least one small through opening in the case of different stencil thicknesses is preferably compared by means of a comparison apparatus with the setpoint area ratio, until a stencil thickness corresponds with an area ratio which is greater than or equal to the setpoint area ratio. Subsequently, the paste stencil with the said stencil thickness is selected.

By way of the method according to the invention, in particular, a stepless paste stencil with a uniform or continuous stencil thickness, that is to say a paste stencil without a stepped section at one or more through holes, is selected.

According to the present invention, a paste stencil having at least one small through opening for paste material for at least one associated small component and at least one large through opening for paste material for at least one associated large component is selected. That is to say, according to the present invention, a paste stencil having a small through opening for paste material for at least one associated small component and a large through opening for paste material for at least one associated large component can be selected. Moreover, in the context of the present invention, a paste stencil having through openings of different small size for paste material for associated small components of different size and through openings of different size for paste material for associated large components of different size can be selected. That is to say, the selection of the paste stencil having at least one small through opening for paste material for at least one associated small component and at least one large through opening for paste material for at least one associated large component is to be understood such that a paste stencil is selected which has at least two through holes of different size. The large component is preferably larger than the small component and/or has a greater cross section parallel to a substrate surface than the small component.

In the present case, paste material is to be understood to mean soldering paste, in particular. However, the present invention is not restricted to this. Thus, other pasty materials or adhesives are also conceivable according to the invention. The paste material is preferably applied onto the substrate by means of a soldering paste printing apparatus such as a screen printer, it being possible for the paste material to be applied onto the substrate fundamentally by way of every type of apparatus for printing paste material. The substrate is to be understood to mean, in particular, a printed circuit board, it being possible for every type of component carrier which can be populated to be understood here. The substrate can be rigid or flexible to a greater or lesser extent. Furthermore, the substrate can have both rigid and flexible regions.

In the context of the present invention, a small component and large component are to be understood to mean all elements which can be populated and can be placed on a substrate. A small or large component can be, in particular, a bipolar or multipolar SMD component or another highly integrated flat component such as a ball grid array, a bare die or a flip chip. Further, a small or large component can be understood to mean a mechanical element such as a connector pin, a plug, a socket or an optoelectronic component such as a light emitting diode or a photodiode.

According to one advantageous development of the present invention, the paste stencil is selected on the basis of a stencil thickness, in the case of which the first area ratio lies between 0.3 and 0.7, in particular is 0.5. It has been proven in current tests with conventional soldering paste that an area ratio between 0.3 and 0.7 leads to satisfactory results in soldering paste printing. The area ratio can also be selected to be even smaller in a manner which is dependent on the paste material which is used. According to the present invention, the paste stencil is preferably selected on the basis of the stencil thickness in such a way that the area ratio is as far as possible equal to or close to the setpoint area ratio. Thus, as much paste material as possible can be applied onto the substrate for the at least one large component by means of the paste stencil. The greater the area ratio which is selected and/or the greater the difference correspondingly between the area ratio and the setpoint area ratio, the simpler it is for the paste material to be able to flow through the through openings, and the less paste material can be provided overall, however, by means of the paste stencil on the basis of the low stencil thickness for the respective components.

Furthermore, it is possible within the context of the method according to the invention that the paste stencil has at least one smallest through opening for paste material for at least one associated smallest component on the substrate, and the at least one smallest through opening has a smaller opening cross section than at least one small through opening, the at least one smallest through opening having a third area ratio which is smaller than the first area ratio, the paste stencil being selected on the basis of a stencil thickness, in the case of which the third area ratio is greater than or equal to a setpoint area ratio. If the paste stencil is selected on the basis of a stencil thickness, in the case of which the third area ratio, that is to say the area ratio of the smallest through opening, is greater than or equal to the setpoint area ratio, it can be ensured that the paste material can flow through the smallest through opening and therefore also through any other through opening, without it being possible for clogging of a through opening or a corresponding formation of residues in a through opening to occur. Nevertheless, it can be ensured that paste material can be applied on the substrate by means of the paste stencil for all components, that is to say the at least one small or smallest component and the at least one large component. In the case of the at least one smallest through opening, the small through opening can also be considered to be a large through opening. The same applies to the ratio between the smallest component and the small component. It goes without saying that the small through opening can also be considered to be the at least one smallest through opening, and the small component can also be considered to be the at least one smallest component. That is to say, the small through opening can also be the smallest through opening of the paste stencil, and the small component can correspondingly be the smallest component on the substrate or for the substrate.

According to a further aspect of the present invention, a method for applying paste material onto a substrate for at least one small component and at least one large component which is larger than the at least one small component is provided. Furthermore, the method has the following steps:
- application of paste material for the at least one small component and the at least one large component by means of a paste stencil which is selected by way of the above-described method, and
- application of additional paste material onto the paste material for the at least one large component, after paste material has been applied by means of the selected paste stencil for the at least one small component and the at least one large component.

As a result, it is possible to apply sufficient paste material onto the substrate both for the at least one small component and for the at least one large component inexpensively, rapidly and reliably. In a first step, an at least partially sufficient paste deposit or at least one certain paste deposit base can first of all be applied on the substrate for each component by means of the selected paste stencil. It can be determined in a second step on the basis of the paste stencil which is selected according to the invention, on which paste deposit bases additional paste material is also to be applied selectively. If a paste stencil has been selected on the basis of a stencil thickness, in the case of which, for example, the third area ratio is equal to a setpoint area ratio, it can be assumed that no additional paste material has to be applied onto the paste material or the corresponding paste deposit for the smallest component, but in contrast additional paste material still has to be applied for the paste material or the corresponding paste deposit for the respective larger components. Therefore, selective additional application of paste material in a targeted manner onto paste material which is already present can take place in the second step. If, for example, a paste stencil has been selected on the basis of a stencil thickness, in the case of which, for example, an area ratio of a second smallest component is equal to a setpoint area ratio, it can be assumed that no additional paste material has to be applied onto the paste material or the corresponding paste deposit for the second smallest component, but in contrast additional paste material still has to be applied for the paste material or the corresponding paste deposit for the respective larger components. Moreover, it can be assumed or there is at least a certain probability that additional paste material still has to be applied onto the paste material or the corresponding paste deposit for the smallest component, since, in the case of the smallest through opening, there is an area ratio which is smaller than an actually permissible area ratio for the smallest through opening, as a result of which clogging in the smallest through opening or corresponding residues in the latter can occur, as a result of which in turn insufficient paste material might pass onto the substrate.

It is possible in one development that the additional paste material is applied by means of a dispenser, in particular by means of a jet dispenser. Dispensers and, in particular, jet dispensers are suitable in a particularly advantageous way for the selective additional or additive application according to the invention of paste material. As a result, it is possible to apply sufficient paste material for both the at least one small component and for the at least one large component onto the substrate rapidly, reliably and efficiently by means of only a single paste stencil and the dispenser or a corresponding injector.

According to a further aspect of the present invention, a selection apparatus for selecting a paste stencil for paste printing onto a substrate is provided, the paste stencil having at least one small through opening for paste material for at least one associated small component on the substrate and at least one large through opening for paste material for at least one associated large component on the substrate, and the at least one small through opening having a smaller opening cross section than the at least one large through opening, and the at least one small through opening having a first area ratio and the at least one large through opening having a second area ratio which is greater than the first area ratio. Here, the selection apparatus is designed and configured in such a way that the paste stencil is selected on the basis of a stencil thickness, in the case of which the first area ratio is greater than or equal to a setpoint area ratio.

Therefore, the apparatus according to the invention entails the same advantages as have been described in detail with reference to the method according to the invention. The selection apparatus preferably has a comparison apparatus which is configured and designed, in order to select the paste stencil, to compare the first area ratio in the case of a fixed opening cross section of the small through opening in the case of different stencil thicknesses with the setpoint area ratio, until a stencil thickness corresponds with an area ratio which is greater than or equal to the setpoint area ratio. Subsequently, a paste stencil having the said stencil thickness can be selected by means of the selection apparatus.

According to one development, the paste stencil can be selected on the basis of a stencil thickness, in the case of which the first area ratio lies between 0.3 and 0.7, in particular is 0.5. Moreover, it is possible that the paste stencil has at least one smallest through opening for paste material for at least one associated smallest component on the substrate, and the at least one smallest through opening has a smaller opening cross section than at least one small through opening, the at least one smallest through opening having a third area ratio which is smaller than the first area ratio, the selection apparatus being designed and configured in such a way that the paste stencil is selected on the basis of a stencil thickness, in the case of which the third area ratio is greater than or equal to a setpoint area ratio.

According to a further aspect of the present invention, a system for applying paste material to components of a substrate having at least one small component and at least one large component which is larger than the at least one small component is provided. The system has a selection apparatus as shown above. Moreover, the system has a paste printing apparatus for printing paste material for the at least one small component and the at least one large component onto the substrate by means of a paste stencil which is selected by way of the selection apparatus. Moreover, the system has a dispenser for applying additional paste material onto the paste material for the at least one large component, after paste material has been applied for the at least one small component and the at least one large component by means of the selected paste stencil.

Therefore, the system according to the invention also entails the same advantages as have been described in detail with reference to the method according to the invention. The paste printing apparatus is preferably configured as a screen printing apparatus.

It is possible according to one development that the selection apparatus, the paste printing apparatus and the dispenser are preferably connected to a controller, by means of which the application of the paste material can be carried out in an automated manner. That is to say, the system has a controller, by means of which the selection apparatus can be actuated in such a way that a suitable paste stencil can be selected or is selected according to the invention. Furthermore, the paste printing apparatus can be actuated by way of the controller in such a way that paste material for the at least one small component and the at least one large component can be applied onto the substrate by means of the paste stencil which is selected by way of the selection apparatus. Moreover, the dispenser can also be actuated by way of the controller in such a way that additional paste material according to the invention can be applied onto the paste material for the at least one large component, after paste material has been applied for the at least one small component and the at least one large component by means of the selected paste stencil. Time and therefore costs can be saved by way of the automation capability of the system.

Further measures which improve the invention result from the following description relating to different exemplary embodiments of the invention which are shown diagrammatically in the figures. All features and/or advantages which are apparent from the claims, the description or the drawing, including structural details and spatial arrangements, can be essential to the invention both per se and also in various combinations.

In the drawing, in each case diagrammatically:
Figure 1 shows paste printing by way of a paste stencil according to a method of the prior art,
Figure 2 shows paste printing by way of a paste stencil which has been selected according to one method of the present invention,
Figure 3 shows a first work step of paste printing by way of a paste stencil which is selected according to the invention,
Figure 4 shows a second work step of paste printing by way of a dispenser which is actuated according to the invention, and
Figure 5 shows a substrate with components which are arranged on paste material in a system according to the invention.

Elements with the same function and method of operation are provided with the same reference numerals in Figures 1 to 5.

The paste printing which is shown in Figure 1 has already been acknowledged in the introduction of the description and is not to be explained again at this point.

Figure 2 shows a substrate 20, onto which paste material 30 has been applied by means of a paste stencil 10 which is selected according to the invention. The paste stencil 10 has a smallest through opening 11 a, a small through opening 11b and two large through openings 12. The smallest through opening 11 a and the small through opening 11 b can be considered in each case to be the at least one small through opening 11 a, 11 b according to the invention. As can be seen in Figure 2, both the smallest through opening 11a and the small through opening 11b in each case have a smaller opening cross section than the respective large through opening 12. In the case of the uniform stencil thickness H of the paste stencil 10, both the smallest through opening 11 a and the small through opening 11 b therefore have an area ratio (a first and third area ratio, respectively) which is smaller than the area ratio (second area ratio) of the respective large through opening.

The paste stencil 10 which is shown in Figure 3 has been selected on the basis of a stencil thickness h, in the case of which the area ratio of the smallest through opening 11 a is greater than a setpoint area ratio, as a result of which the paste material 30 can flow through all through openings 11 a, 11 b, 12, without forming residues in the through openings 11 a, 11 b, 12.

With reference to Figure 3, Figure 4 and Figure 5, a method for applying paste material 30 onto a substrate 20 will be described in the following text for two small components 21a, 21 b and two large components 22 which are larger than the small components 21a, 21 b.

In a first step, paste material 30 for the two small components 21 a, 21 b and the two large components 22 is first of all, as shown in Figure 3, applied onto the substrate 20 for this purpose by means of the paste stencil 10 which is selected as described above. To this end, paste material 30 is pressed onto the substrate 20 through the through holes 11 a, 11 b, 12 in the screen printing method by means of a squeegee 61 which is moved over the paste stencil 10 in the arrow direction. Here, the squeegee 61 is a constituent part of a paste printing apparatus 60.

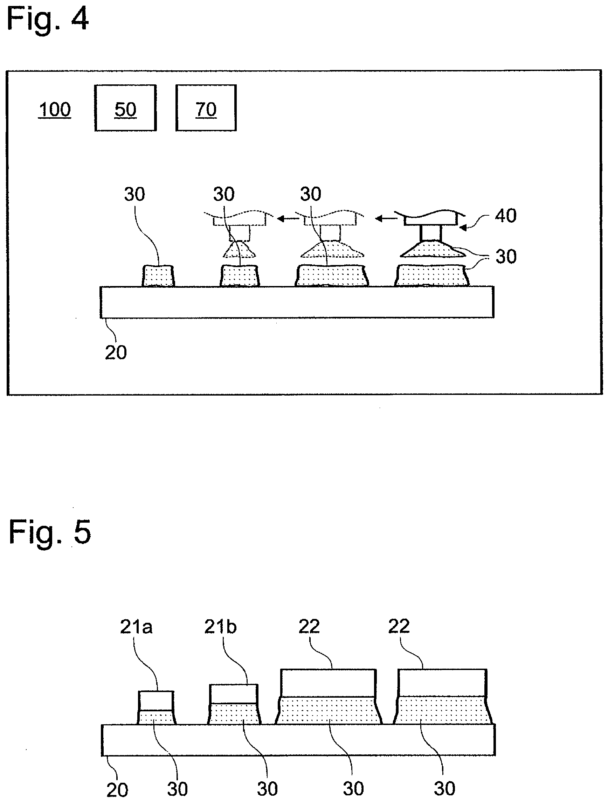

In a second step, as shown in Figure 4, selectively additional paste material 30 is then applied onto the paste material 30 for the small component 21 b and the two large components 22 by means of a dispenser 40.

Figure 3 and Figure 4 likewise show the system 100 according to the invention having a selection unit 50, a paste printing apparatus 60 and a controller 70. For more comprehensible illustration, the selection apparatus 50, the paste printing apparatus 60 and the dispenser 40 have been shown in different figures. However, the system 100 according to the invention is to be understood in such a way that the selection apparatus 50, the paste printing apparatus 60 and the dispenser 40 are arranged so as to belong to the system 100. Thus, the system 100 can be configured, for example, as a soldering paste printer having the selection apparatus 50, which soldering paste printer has, furthermore, a paste printing apparatus 60 which is configured as a screen printing apparatus, and, in an additional processing region, a dispenser arrangement having from 1 to n gantries with respective dispensers 40 which can be deflected in each case in the x, y and/or z-axes.

In the system 100 which is shown by Figure 3 and Figure 4, the selection apparatus 50, the paste printing apparatus 60 and the dispenser 40 are electrically connected to a controller 70 using wires or in a wireless manner, the controller 70 being designed and configured in such a way that the application of the paste material 30 can be carried out in an automated manner.

Figure 5 shows a smallest component 21 a, a small component 21 b and two large components 22 which are in each case connected to the substrate 20 via paste material 30.

### List of Reference Numerals

- 10: Paste stencil
- 11a: Smallest through opening
- 11b: Small through opening
- 12: Large through opening
- 20: Substrate
- 21a: Smallest component
- 21b: Small component
- 22: Large component
- 30: Paste material
- 40: Dispenser
- 50: Selection apparatus
- 60: Paste printing apparatus
- 61: Squeegee
- 70: Controller
- 100: System

## Claims

1. Method for selecting a paste stencil (10) for paste printing onto a substrate (20), the paste stencil (10) having at least one small through opening (11a, 11 b) for paste material (30) for at least one associated small component (21a, 21 b) on the substrate (20) and at least one large through opening (12) for paste material (30) for at least one associated large component (22) on the substrate (20), and the at least one small through opening (11 a, 11b) having a smaller opening cross section than the at least one large through opening (12), and the at least one small through opening (11 a, 11 b) having a first area ratio and the at least one large through opening (12) having a second area ratio which is greater than the first area ratio, **characterized in that** the paste stencil (10) is selected on the basis of a stencil thickness (h), in the case of which the first area ratio is greater than or equal to a setpoint area ratio.

2. Method according to Claim 1, **characterized in that** the paste stencil (10) is selected on the basis of a stencil thickness (h), in the case of which the first area ratio lies between 0.3 and 0.7, in particular is 0.5.

3. Method according to Claim 1 or 2, the paste stencil (10) having at least one smallest through opening (11a) for paste material (30) for at least one associated smallest component (21a) on the substrate (20), and the at least one smallest through opening (11 a) having a smaller opening cross section than at least one small through opening (11 b), the at least one smallest through opening (11a) having a third area ratio which is smaller than the first area ratio, **characterized in that** the paste stencil (10) is selected on the basis of a stencil thickness (h), in the case of which the third area ratio is greater than or equal to a setpoint area ratio.

4. Method for applying paste material (30) onto a substrate (20) for at least one small component (21 a, 21b) and at least one large component (22) which is larger than the at least one small component (21 a, 21 b), **characterized by** the steps:
- application of paste material (30) for the at least one small component (21 a, 21 b) and the at least one large component (22) by means of a paste stencil (10) which is selected by way of a method according to one of Claims 1 to 3, and
- application of additional paste material (30) onto the paste material (30) for the at least one large component (22), after paste material (30) has been applied by means of the selected paste stencil (10) for the at least one small component (21a, 21 b) and the at least one large component (22).

5. Method according to Claim 4, **characterized in that** the additional paste material (30) is applied by means of a dispenser (40), in particular by means of a jet dispenser.

6. Selection apparatus (50) for selecting a paste stencil (10) for paste printing onto a substrate (20), the paste stencil (10) having at least one small through opening (11a, 11b) for paste material (30) for at least one associated small component (21a, 21 b) on the substrate (20) and at least one large through opening (12) for paste material (30) for at least one associated large component (22) on the substrate (20), and the at least one small through opening (11a, 11b) having a smaller opening cross section than the at least one large through opening (12), and the at least one small through opening (11 a, 11 b) having a first area ratio and the at least one large through opening (12) having a second area ratio which is greater than the first area ratio, **characterized in that** the selection apparatus (50) is designed and configured in such a way that the paste stencil (10) is selected on the basis of a stencil thickness (h), in the case of which the first area ratio is greater than or equal to a setpoint area ratio.

7. Selection apparatus (100) according to Claim 6, **characterized in that** the paste stencil (10) is selected on the basis of a stencil thickness (h), in the case of which the first area ratio lies between 0.3 and 0.7, in particular is 0.5.

8. Selection apparatus (50) according to Claim 6 or 7, the paste stencil (10) having at least one smallest through opening (11 a) for paste material (30) for at least one associated smallest component (21a) on the substrate (20), and the at least one smallest through opening (11a) having a smaller opening cross section than at least one small through opening (11 b), the at least one smallest through opening (11 a) having a third area ratio which is smaller than the first area ratio, **characterized in that** the selection apparatus (50) is designed and configured in such a way that the paste stencil (10) is selected on the basis of a stencil thickness (h), in the case of which the third area ratio is greater than or equal to a setpoint area ratio.

9. System (100) for applying paste material (30) to components (21a, 21 b, 22) of a substrate (20) having at least one small component (21a, 21b) and at least one large component (22) which is larger than the at least one small component (21a, 21 b), **characterized by** a selection apparatus (50) according to one of Claims 6 to 8, a paste printing apparatus (60) for printing paste material (30) for the at least one small component (21 a, 21 b) and the at least one large component (22) onto the substrate (20) by means of a paste stencil (10) which is selected by way of the selection apparatus (100), and a dispenser (40) for applying additional paste material (30) onto the paste material (30) for the at least one large component (22), after paste material (30) has been applied by means of the selected paste stencil (10) for the at least one small component (21 a, 21 b) and the at least one large component (22).

10. System (100) according to Claim 9, **characterized in that** the selection apparatus (50), the paste printing apparatus (60) and the dispenser (40) are connected to a controller (70), by means of which the application of the paste material (30) can be carried out in an automated manner.
